# FASCICULE DE BREVET EUROPEEN

(11) **EP 2 471 174 B1**
(45) Date de publication et mention de la délivrance du brevet: **19.09.2018**
(21) Numéro de dépôt: 10739955.2
(22) Date de dépôt: 10.08.2010
(51) Int. Cl.: H03F 1/32, H03F 3/189, H03F 3/68, H04B 7/185

(54) **DISPOSITIF AMPLIFICATEUR DE CANAL LINÉARISEUR DOUBLE CHAÎNE RF ET SATELLITE DE TÉLÉCOMMUNICATION COMPORTANT CE DISPOSITIF**
DOPPEL HF-KETTE LINEARISIERER-KANALVERSTÄRKER VORRICHTUNG UND TELEKOMMUNIKATIONSSATELLITEN MIT EINER SOLCHEN VORRICHTUNG
DOUBLE RF CHAIN CHANNEL AMPLIFIER - LINEARIZER DEVICE AND TELECOMMUNICATIONS SATELLITE COMPRISING SAID DEVICE

(30) Priorité: 28.08.2009 FR 0904108
(43) Date de publication de la demande: 04.07.2012
(73) Titulaire: THALES, 92400 Courbevoie (FR)
(72) Inventeur: MOUCHON, Grégory, 31600 Muret (FR); MAYNARD, Jean, F-31520 Ramonville Saint Agne (FR); RODRIGUEZ, Raoul, F-31150 Bruguières (FR); JAUBERT, Pierre, 05120 Les Vigneaux (FR)
(74) Mandataire: Esselin, Sophie
(86) Numéro de dépôt international: PCT/EP2010/061641
(87) Numéro de publication internationale: WO 2011/023534

(56) Documents cités:
- EP-A2- 1 478 088
- US-A1- 2004 185 775

## Description

La présente invention concerne un dispositif amplificateur de canal linéariseur double chaîne RF et un satellite de télécommunication comportant ce dispositif. Elle s'applique notamment au domaine des télécommunications par satellite et en particulier aux chaînes d'émission radiofréquence des répéteurs de satellite.

Le document US2004/0185775 décrit un dispositif selon le préambule de la revendication 1. Dans la plupart des architectures charge utile, les répéteurs installés à bord des satellites comportent un grand nombre de canaux radiofréquence RF indépendants comportant chacun un équipement de pré-amplification des signaux radiofréquence reçus par le répéteur, destiné à fournir la puissance requise à l'entrée d'un tube à ondes progressives. Ce tube à ondes progressives est un amplificateur hyperfréquence de puissance utilisé pour réémettre les signaux reçus vers un abonné. On le fait fonctionner au voisinage de sa puissance de saturation, ce qui entraîne une réponse non linéaire du tube, cette réponse non linéaire pouvant être corrigée par une fonction linéariseur éventuellement embarquée dans l'équipement de pré-amplification disposé en amont du tube, l'équipement de pré-amplification étant alors appelé amplificateur de canal linéariseur.

Le dispositif amplificateur de canal linéariseur dédié à chaque chaîne RF comporte un module amplificateur, éventuellement un module linéariseur et un module de télécommande et de télémétrie. Le module de télécommande et de télémétrie pilote le dispositif amplificateur de canal linéariseur et gère les télécommunications avec une station sol. Le module de télécommande et de télémétrie comporte une partie télécommande qui paramètre le module amplificateur et le linéariseur pour l'adapter aux conditions d'utilisation déterminées par le trafic des données à transmettre et de façon générale par les contraintes spécifiques au bilan de liaison, ainsi qu'une partie télémétrie chargée de gérer et de transmettre les mesures réalisées par le dispositif amplificateur de canal linéariseur vers la station sol. Le module de télécommande et de télémétrie peut également gérer et transmettre des télémétries provenant d'autres équipements du satellite tels que par exemple celles du système d'alimentation des tubes à ondes progressives.

Les répéteurs comportant un grand nombre de canaux comportant chacun un dispositif amplificateur de canal linéariseur dédié et chaque dispositif amplificateur de canal linéariseur comportant plusieurs modules indépendants, cette architecture présente des problèmes d'encombrement et de coût de production d'autant plus important que le nombre de canaux est grand.

L'invention a pour but de réaliser un dispositif amplificateur de canal linéariseur comportant un nombre de composants réduit et permettant de diminuer le coût de production et l'encombrement de chaque chaîne RF.

Pour cela, l'invention concerne un dispositif amplificateur selon la revendication 1.

Avantageusement, le module de télécommande et de télémétrie assure l'aiguillage et la gestion des signaux de télécommande dédiés à chacun des deux modules amplificateurs de canal et la gestion des signaux de télémesures réalisées par les deux modules amplificateurs de canal.

Eventuellement, chaque chaîne radiofréquence comporte en outre un linéariseur connecté au module amplificateur de canal respectif et au module de télécommande et de télémétrie et le module de télécommande et de télémétrie gère en outre des signaux de télémesures réalisées par les deux linéariseurs.

Avantageusement, le module de télécommande et de télémétrie comporte un bus de communication série ou parallèle commun aux deux chaînes radiofréquence.

Préférentiellement, le module de télécommande et de télémétrie comporte une adresse physique unique pour tous les signaux de télécommande et de télémétrie relatifs aux deux chaînes radiofréquence.

Avantageusement, le module de télécommande et de télémétrie comporte en outre des sorties de télécommande connectées en entrée d'un conditionneur double, ou de deux conditionneurs électroniques de puissance, raccordé à deux tubes à ondes progressives associés à chaque chaîne radiofréquence. Dans ce cas, le module de télécommande et de télémétrie comporte en outre un système de gestion des télémétries analogiques et numériques de chaque conditionneur de puissance via une ou des interfaces dédiées.

L'invention concerne également un satellite de télécommunication comportant au moins un dispositif amplificateur de canal linéariseur double chaîne RF.

D'autres particularités et avantages de l'invention apparaîtront clairement dans la suite de la description donnée à titre d'exemple purement illustratif et non limitatif, en référence aux dessins schématiques annexés qui représentent :
- figure 1 : un schéma de principe d'un exemple de dispositif amplificateur de canal linéariseur double chaîne RF, selon l'invention ;
- figure 2 : un schéma détaillé du dispositif amplificateur de canal linéariseur double chaîne RF, selon l'invention ;

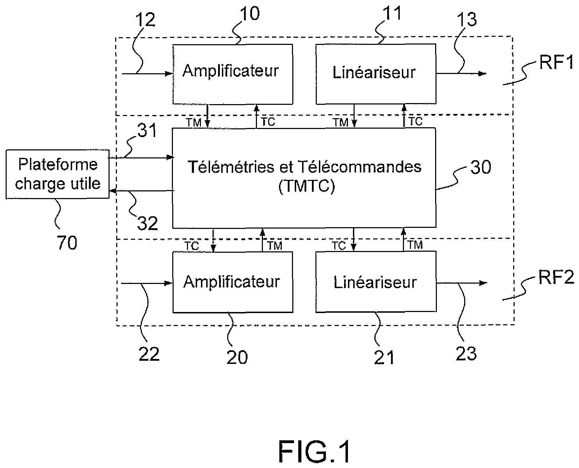

Le schéma de principe du dispositif amplificateur de canal linéariseur double chaîne RF représenté sur la figure 1 comporte deux chaînes radiofréquences RF1, RF2 indépendantes, relatives à deux canaux différents d'émission, connectées à un seul et même module de télécommande et de télémétrie TMTC 30. Le module de télécommande et de télémétrie 30, commun aux deux chaînes RF1, RF2 peut éventuellement comporter une adresse physique unique pour tous les signaux de télécommande TC et de télémétrie TM relatifs aux deux chaînes RF1, RF2. L'aiguillage et la gestion des signaux dédiés à chacune des chaînes RF1, RF2 sont réalisés en interne du module de télécommande et de télémétrie 30 par un dispositif électronique dédié, par exemple de type ASIC. Le module de télécommande et de télémétrie 30 communique avec une station sol par l'intermédiaire d'une charge utile 70 comportant un récepteur/émetteur associé à un système d'antennes d'émission et de réception disposé sur la plate-forme du satellite. Le module de télécommande et de télémétrie 30 dialogue avec la plate-forme du satellite par l'intermédiaire d'un bus de communication série ou parallèle schématisé par une entrée 31 destinée à recevoir tous les signaux de télécommande dédiés aux deux chaînes RF1, RF2 et provenant de la station au sol, et une sortie 32 destinée à émettre vers la station au sol tous les signaux de télémétries provenant des mesures réalisées par les deux chaînes RF1, RF2.

Chaque chaîne RF1, RF2 comporte un module amplificateur de canal (en anglais : channel amplifier) 10, 20 comportant une entrée radiofréquence 12, 22 destinée à recevoir des signaux radiofréquence dans une bande de fréquence prédéterminée, et éventuellement un linéariseur 11, 21 comportant une sortie radiofréquence 13, 23 reliée à un tube à ondes progressives TWT (en anglais :travelling wave tube) chargé d'amplifier les signaux reçus sur le canal correspondant à ladite chaîne RF1, RF2, et qui seront ré-émis vers le sol par l'intermédiaire des antennes d'émission.

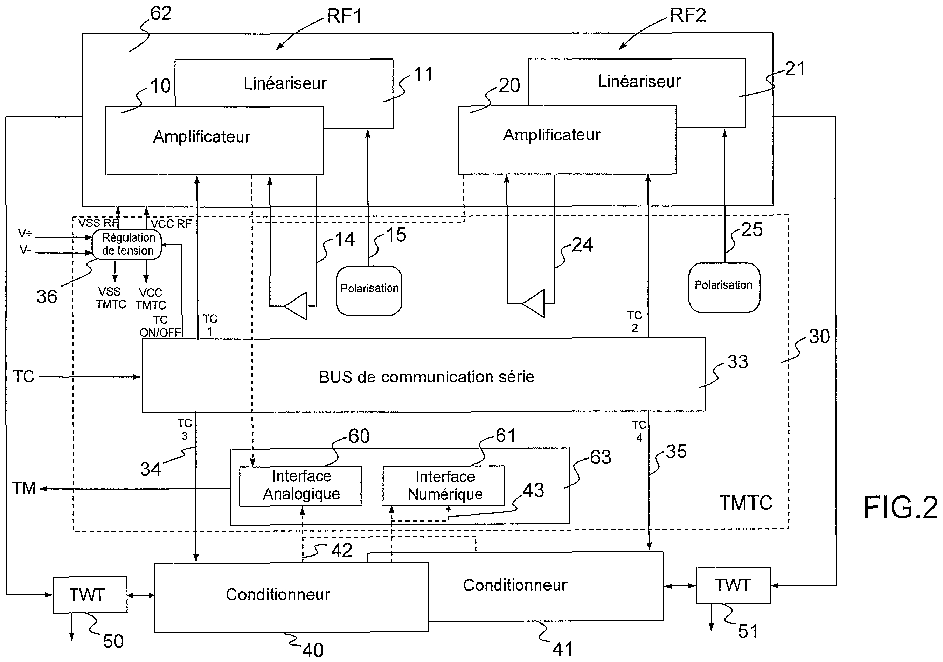

Comme représenté sur la figure 2, le module de télécommande et de télémétrie 30 comporte un bus de communication série ou parallèle 33 commun aux deux chaînes RF1, RF2. Ceci permet, pour un même nombre d'abonnés, de pouvoir éventuellement disposer d'une adresse et d'une interface unique pour ces deux chaînes RF1, RF2, de diminuer le nombre de composants du module de télécommande et de télémétrie ainsi que le nombre de connexions entre les équipements et donc de simplifier le harnais de liaison permettant les connexions entre les équipements. Ceci permet également pour une complexité de harnais équivalente, de doubler la capacité globale en nombre d'abonnés.

Le module de télécommande et de télémétrie 30 peut être également destiné à commander deux conditionneurs électroniques de puissance simples (en anglais : electronic power conditioner) 40, 41, ou un seul conditionneur électronique de puissance double, de deux tubes à ondes progressives, TWT, 50, 51 associés à chaque chaîne RF1, RF2. Les interfaces entre le module de télécommande et de télémétrie 30 et les conditionneurs électroniques 40, 41 sont schématisées par les deux sorties de télécommande 34, 35. De même, le module de télécommande et de télémétrie 30 comporte en outre un système de gestion 63 des télémétries de chaque conditionneur de puissance 40, 41, ou du conditionneur de puissance double, schématisées par les sorties de télémétrie 42, 43 connectées en entrée d'une interface analogique 60 et d'une interface numérique ou logique 61. Les deux interfaces 60, 61 font partie du module de télécommande et de télémétrie 30 et permettent de transmettre les propres télémétries de chaque conditionneur de puissance 40, 41 à la station sol par l'intermédiaire du module de télécommande et de télémétrie 30.

D'un point de vue fonctionnel, le module de télécommande et de télémétrie 30 comporte un ensemble de composants électroniques permettant par exemple d'assurer les fonctions de numérisation des télémétries analogiques des deux modules amplificateurs 10, 20 de canaux et le ou les conditionneurs de puissance 40, 41 correspondants, d'assurer les gestions des télécommandes TC1, TC2, TC3, TC4 dédiées à la configuration des deux modules amplificateurs 10, 20 de canaux et du ou des deux conditionneurs de puissance 40, 41 correspondants, d'assurer éventuellement la régulation de la puissance de sortie des deux modules amplificateurs 40, 41 de canaux par l'intermédiaire de boucles 14, 24 de régulation du gain correspondantes, de fournir les tensions d'alimentation 36 aux deux chaines RF1, RF2, et d'assurer la polarisation 15, 25 des deux linéariseurs 11, 21.

Un maximum de fonctions et donc de composants électroniques sont mises en commun afin de réduire le coût associé. Les deux chaînes RF1, RF2 sont indépendantes et peuvent être commandées indépendamment l'une de l'autre, les configurations des deux chaines RF1, RF2 peuvent donc être complètement différentes. Avantageusement, les deux chaînes RF1 et RF2 peuvent être intégrées dans un même boîtier 62.

## Revendications

1. Dispositif amplificateur de canal linéaliseur double chaîne RF destiné à être embarqué à bord d'un satellite de télécommunication, comportant deux chaînes radiofréquence (RF1, RF2)
Indépendantes, chaque chaîne radiofréquence (RF1, RF2) correspondant à un canal de communication de signaux radiofréquence et comportant un module amplificateur de canal (10, 20) , **caractérisé par**
un conditionneur électronique de puissance (40, 41),les deux modules amplificateur de canaux (10, 20) et les deux
conditionneurs électriques de puissance (40, 41) étant connectés à un seul et même module de télécommande et de télémétrie (30), le module de télécommande et de télémétrie (30) comportant un dispositif de régulation de tension (36) qui fournit les tensions d'alimentation aux deux chaînes radiofréquence (RF1, RF2), des boucles (14, 24) de régulation du gain des deux modules amplificateurs de canaux (10, 20), et un ensemble de composants électroniques
assurant la numérisation des télémétries analogiques des deux modules amplificateurs de canaux (10, 20) et la gestion des télécommandes dédiées à la configuration des deux modules amplificateurs de canaux (10, 20) et des conditionneurs électroniques de puissance (40, 41).

2. Dispositif selon la revendication 1, **caractérisé en ce que** chaque chaîne radiofréquence (RF1, RF2) comporte en outre un linéariseur (11, 21) connecté au module amplificateur de canal (10, 20) respectif et au module de télécommande et de télémétrie (30) et **en ce que** le module de télécommande et de télémétrie (30) gère en outre des signaux de télémesures réalisées par les deux linéariseurs (11, 21) et assure la polarisation (15, 25) des deux linéariseurs (11, 21).

3. Dispositif selon l'une des revendications précédentes, **caractérisé en ce que** le module de télécommande et de télémétrie (30) comporte un bus de communication (33) série ou parallèle commun aux deux chaînes radiofréquence (RF1, RF2).

4. Dispositif selon l'une des revendications précédentes, **caractérisé en ce que** le module de télécommande et de télémétrie (30) comporte une adresse physique unique pour tous les signaux de télécommande et de télémétrie relatifs aux deux chaînes radiofréquence.

5. Dispositif selon la revendication 4, **caractérisé en ce que** le module de télécommande et de télémétrie (30) comporte des sorties de télécommande (34, 35) connectées respectivement en entrée des deux conditionneurs électroniques de puissance (40, 41) raccordés respectivement à deux tubes à ondes progressives (50, 51) associés à chaque chaîne radiofréquence (RF1, RF2).

6. Dispositif selon la revendication 5, **caractérisé en ce que** le module de télécommande et de télémétrie (30) comporte en outre un système de gestion (63) des télémétries analogiques et numériques de chaque conditionneur de puissance (40, 41) via une interface analogique (60) et une interface numérique (61) dédiées.

7. Satellite de télécommunication **caractérisé en ce qu'**il comporte au moins un dispositif amplificateur de canal linéariseur double chaîne RF selon l'une quelconque des revendications précédentes.

## Patentansprüche

1. Kanalverstärkungsvorrichtung für einen HF-Zweikanal-Linearisierer, der vorgesehen wird, an Bord eines Fernmeldesatelliten mitgenommen zu werden, der zwei unabhängige Hochfrequenzkanäle (HF1, HF2) aufweist, wobei jeder Hochfrequenzkanal (HF1, HF2) einem Kommunikationskanal der Hochfrequenzsignale entspricht und einen Kanalverstärkungsmodul (10, 20) aufweist, **gekennzeichnet durch** einen elektronischen Leistungsaufbereiter (40, 41), wobei die beiden Kanalverstärkungsmodule (10, 20) und die beiden elektrischen Leistungsaufbereiter (40, 41) mit ein und demselben Fernsteuerungs- und Fernmessungsmodul (30) verbunden sind, wobei das Fernsteuerungs- und Fernmessungsmodul (30) eine Spannungsregelungsvorrichtung (36), die die Versorgungsspannungen an die beiden Hochfrequenzkanäle (HF1, HF2) liefert, Verstärkungsregelungsschleifen (14, 24) der beiden Kanalverstärkungsmodule (10, 20) und eine Gesamtheit von Elektronikbauelementen aufweist, die die Digitalisierung der analogen Fernmessungen der beiden Kanalverstärkungsmodule (10, 20) und die Verwaltung der Fernsteuerungen sicherstellen, die für die Konfiguration der beiden Kanalverstärkungsmodule (10, 20) und der elektronischen Leistungsaufbereiter (40, 41) dediziert sind.

2. Vorrichtung nach Anspruch 1, **dadurch gekennzeichnet, dass** jeder Hochfrequenzkanal (HF1, HF2) ferner einen mit dem jeweiligen Kanalverstärkungsmodul (10, 20) und dem Fernsteuerungs- und Fernmessungsmodul (30) verbundenen Linearisierer (11, 21) aufweist, und dass das Fernsteuerungs- und das Fernmessungsmodul (30) ferner durch die beiden Linearisierer (11, 21) ausgeführte Fernmessungssignale verwaltet und die Polarisation (15, 25) der beiden Linearisierer (11, 21) sicherstellt.

3. Vorrichtung nach einem der vorhergehenden Ansprüche, **dadurch gekennzeichnet, dass** das Fernsteuerungs- und Fernmessungsmodul (30) einen für beide Hochfrequenzkanäle (HF1, HF2) gemeinsamen seriellen oder parallelen Kommunikationsbus (33) aufweist.

4. Vorrichtung nach einem der vorhergehenden Ansprüche, **dadurch gekennzeichnet, dass** das Fernsteuerungs- und Fernmessungsmodul (30) eine eindeutige physische Adresse für alle Fernsteuerungs- und Fernmessungssignale in Bezug auf die beiden Hochfrequenzkanäle aufweist.

5. Vorrichtung nach Anspruch 4, **dadurch gekennzeichnet, dass** das Fernsteuerungs- und Fernmessungsmodul (30) Fernsteuerungsausgänge (34, 35) aufweist, die jeweils mit dem Eingang der beiden elektronischen Leistungsaufbereiter (40, 41) verbunden sind, die jeweils an zwei jedem Hochfrequenzkanal (HF1, HF2) zugehörige Wanderfeldröhren (50, 51) angeschlossen sind.

6. Vorrichtung nach Anspruch 5, **dadurch gekennzeichnet, dass** das Fernsteuerungs- und Fernmessungsmodul (30) ferner ein Verwaltungssystem (63) der analogen und digitalen Fernmessungen jedes Leistungsaufbereiters (40, 41) mittels einer dedizierten analogen Schnittstelle (60) und einer dedizierten Schnittstelle (61) aufweist.

7. Fernmeldesatellit, **dadurch gekennzeichnet, dass** er mindestens eine Kanalverstärkungsvorrichtung für HF-Zweikanal-Linearisierer nach einem der vorhergehenden Ansprüche aufweist.

## Claims

1. A lineariser channel amplifier device for a dual RF channel intended to be placed on board a telecommunication satellite, comprising two independent radiofrequency channels (RF1, RF2), each radiofrequency channel (RF1, RF2) corresponding to a communication channel for radiofrequency signals and comprising a channel amplifier module (10, 20), **characterised by** an electronic power conditioner (40, 41), the two channel amplifier modules (10, 20) and the two electronic power conditioners (40, 41) being connected to the same remote control and telemetry module (30), the remote control and telemetry module (30) comprising a voltage control device (36) that supplies the supply voltages to the two radiofrequency channels (RF1, RF2), loops (14, 24) for controlling the gain of the two channel amplifier modules (10, 20) and a set of electronic components for digitising the analogue telemetries of the two channel amplifier modules (10, 20) and for managing remote commands intended for the configuration of the two channel amplifier modules (10, 20) and the electronic power conditioners (40, 41).

2. The device as claimed in claim 1, **characterised in that** each radiofrequency channel (RF1, RF2) further comprises a lineariser (11, 21) connected to the respective channel amplifier module (10, 20) and to the remote control and telemetry module (30), and **in that** the remote control and telemetry module (30) also manages telemetry signals produced by the two linearisers (11, 21) and implements the biasing (15, 25) of the two linearisers (11, 21).

3. The device as claimed in any one of the preceding claims, **characterised in that** the remote control and telemetry module (30) comprises a serial or parallel communication bus (33) common to the two radiofrequency channels (RF1, RF2).

4. The device as claimed in any one of the preceding claims, **characterised in that** the remote control and telemetry module (30) comprises a single physical address for all the remote control and telemetry signals relating to the two radiofrequency channels.

5. The device as claimed in claim 4, **characterised in that** the remote control and telemetry module (30) comprises remote control outputs (34, 35) respectively connected to the input of the two electronic power conditioners (40, 41) respectively connected to two travelling wave tubes (50, 51) associated with each radiofrequency channel (RF1, RF2).

6. The device as claimed in claim 5, **characterised in that** the remote control and telemetry module (30) further comprises a management system (63) for managing the analogue and digital telemetries of each power conditioner (40, 41) via a dedicated analogue interface (60) and digital interface (61).

7. A telecommunication satellite, **characterised in that** it comprises at least one lineariser channel amplifier device for a dual RF channel as claimed in any one of the preceding claims.
